# EUROPEAN PATENT APPLICATION

(11) **EP 0 960 855 A1**
(43) Date of publication of application: **01.12.1999**
(21) Application number: 99110058.7
(22) Date of filing: 21.05.1999
(51) Int. Cl.: C01F 7/02, H05K 1/03, B32B 5/28, B32B 27/18

(54) **Non hygroscopic thermally stable aluminium hydroxide**

(30) Priority: 29.05.1998 EP 98109925
(71) Applicant: Martinswerk GmbH für chemische und metallurgische Produktion, 50126 Bergheim (DE)
(72) Inventor: Brown, Neil, Dr., 50126 Bergheim (DE); Aggleton, Michael, Dr., Hucclecote, GL3 3NH Gloucester (GB)
(74) Representative: Winter, Brandl, Fürniss, Hübner, Röss, Kaiser, Polte, Kindermann Partnerschaft

(57) **Abstract**

A non hygroscopic thermally stable aluminium hydroxide is described which is particularly useful for the preparation of thermally stable and fire retardant laminates for printed circuit boards.

## Description

The present invention relates to a non hygroscopic thermally stable aluminium hydroxide and its application in thermally stable fire retardant laminates for printed circuit boards.

Printed circuit board laminate types are defined by the American NEMA (National Electrical Manufacturers Association) standard, the terminology is accepted world-wide. Generally, laminates are categorized according to the type of reinforcement used, i. e., cellulose paper or glass. Typically, the type FR-2 uses paper only, CEM-1 uses paper and woven glass, while type CEM-3 contains both woven and non-woven glass. The type FR-4 contains woven glass only.

To achieve the required V0 level of fire retardancy according to American Underwriters Laboratories' standard UL-94, it is necessary to add either fire retardant chemicals to the polymer system or build halogens or phosphorous into the backbone of the polymer itself. On combustion, these additives help to extinguish the fire. However, in the process of doing so they produce toxic and corrosive gases. In the case of combustion of FR-2 laminates, which contain phosphorous compounds, phosphoric acid is formed. CEM-1, CEM-3 and FR-4 laminates which contain brominated epoxy resin, produce corrosive and toxic hydrogen bromide on combustion.

It is well known in the art that aluminium hydroxide may be used to improve the fire retardancy of synthetic polymer systems based on for example epoxy, polyester, and vinyl ester resins because the polymers decompose in the same temperature range as the aluminium hydroxide. However, the thermal stability of the gibbsite form of aluminium hydroxide (Al(OH)₃ or sometimes represented as Al₂O₃.3H₂O) is insufficient at the temperatures used to solder components to a printed circuit board laminate, This can result in blistering of the laminate thereby rendering it unusable.

It is known that when gibbsite type aluminium hydroxide is heat treated in air it is partially converted to the mono hydrate form, boehmite (AlOOH or Al₂O₃.H₂O) which improves thermal stability but to the detriment of fire retardancy.

Japanese patent disclosure JP-A 60/203 438 describes a CEM-3 laminate containing heat treated gibbsite type aluminium hydroxide which has improved thermal stability over standard aluminium trihydroxide but which does not give the required level of fire retardancy so that brominated epoxy resin has to be used to achieve the UL 94 V0 rating. In such circumstances, and in the absence of superior fire properties, other inorganic materials such as talc or clay could also be used.
GB patent application 9700708.2 describes superior CEM-3 laminates having good thermal stability, being halogen/phosphorous free and meeting the UL 94 V0 requirement by introducing a thermally stable aluminiumhydroxide to the laminate.
However it has been found that these thermally stable aluminum hydroxides have a tendency to absorb moisture. This moisture significantly reduces solder resistance of the laminates. The thermally stable aluminum hydroxide needs accordingly and optionally to be applied more or less immediately after production. It has been found that the moisture may become firmly bound on the surface with the effect that the techniques commonly applied to remove surface moisture, such as prior heat treatment at 110 °C or azeotropic removal with the acetone used in the laminating system may not satisfactorily work.

The object of the present invention therefore is to further improve the application and characteristics of the thermally stable aluminum hydroxide towards a significant lower tendency to absorb moisture. Further object of the invention is to produce laminates, in particular CEM-3 laminates, which have good thermal stability, are halogen/phosphorous free, meet the UL 94 V0 requirement and finally show excellent solder and moisture resistance of the laminates produced.

This object has been achieved with the non hygroscopic thermally stable aluminium hydroxide according to claim 1, by a method for its preparation according to claim 6, the laminate containing the new and inventive non hygroscopic thermally stable aluminium hydroxide according to claim 10 and with a method for producing the laminate according to claim 12.

The non hygroscopic thermally stable aluminium hydroxide comprises a thermally stable aluminium hydroxide of the molecular formula Al₂O₃.nH₂O wherein n has a value of >2.6 to <2.9 which is surface treated with a silane.

Basis for the non hygroscopic thermally stable aluminium hydroxide according to the present invention is the thermally stable aluminum hydroxide as described in detail in GB patent application 9700708.2.
This thermally stable aluminum hydroxide can as described therein be created by a size reduction of an aluminiumhydroxide agglomerate with an average particle size D50 % of 40 to 80 µm preferably of 50 to 70 µm crystallized out from a typical Bayer process - sodium aluminate solution.

Any size reduction technique e. g., ball milling, which separates the crystals present within coarser agglomerates with little or no gross fracture of the single crystals can be applied. A simultaneous broadening of the particle size distribution due to attrition and the absence of crystal breakage by gross fracture improves the processability of the thermally stable aluminium hydroxide in the respective resin system.

The subsequent thermal stabilization can be achieved by simply heating the material recovered from the size reduction treatment at a temperature and during a time sufficient to reduce the water loss on ignition from 34.5 wt.% (n = 3) to a level corresponding to the n value as mentioned above.

In the molecular formula, Al₂O₃.nH₂O, n preferably has a value of 2.7 to 2.8.

A very essential point is the particle size distribution which combines a relatively fine average size with a breadth of particle sizes. This improves the dispersion of the thermally stable aluminium hydroxide in the resin while at the same time minimizing the tendency of the coarser particles to sediment out during processing and avoiding any filtering effects by the non-woven glass.
An optimum particle size distribution allows minimum viscosity of the resin/filler mix at a filling level sufficiently high to achieve the desired flame retardant properties of the laminate without the need to add any other flame retardants.

The preferred average particle size D50% of the thermally stable aluminium hydroxide is 5 to 10 µm. The breadth of the particle size distribution is indicated by the D10% range, i.e., 10% by weight of the particles are smaller than 0.5 to 1.5 µm and the D90% range, i.e., 90 % by weight of the particles are less than 20 to 35 µm in size.

The silane treatment is as a rule effected by first dispersing the thermally stable aluminum hydroxide in a diluent commonly used in the production of laminates for printed circuit boards, preferably a ketone and most preferably acetone.

Before the silane is added it is advantageous to vigorously mix the dispersion with an equipment allowing the application of heavy shearing forces to the mixture like a shearing head mixer or the like.

Thereafter a suitable silane, preferably in liquid form is added in such an amount that the content onto the thermally stable aluminum hydroxide ranges between 0, 1 wt.% and 2 wt.%.
Suitable silanes are commercially available e. g. from Hüls under the trade name Dynasilan® (Hüls-brochure 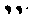 Anwendung von organoftanktionellen Silanen, Dynasilan ®" of October, 1989).
The preferred silane is as a rule an aminoalkylsilane, an epoxyalkylsilane or a vinylsilane. Particularly well suited to epoxy applications is an aminoalkylsilane.

Silane treatment lowers tendency to adsorb moisture and removes moisture adhered to the aluminium hydroxide so that the resulting non hygroscopic thermally stable aluminium hydroxide after silane treatment has a hydrophobic surface free of any adsorbed moisture.

As outlined in the GB patent application 9700708.2 the preferred CEM-3 type laminates are as a rule constructed from two layers of woven fibreglass on the outsides and three layers of non-woven glass tissue in the core.
According to the invention, the laminate for printed circuit boards has surface layers comprising curable resin-impregnated woven glass fabric and one or more intermediate layer(s) comprising curable resin-impregnated non-woven glass, and is characterized in that the intermediate layer(s) contain(s) 200 % by weight to 275 % by weight (based on the resin) of a non hygroscopic thermally stable aluminium hydroxide according to claims 1 to 5.

The curable resin may be an unsaturated polyester resin, an epoxy resin, a vinyl ester resin or any suitable thermosetting compound which on combustion decomposes in the same temperature range as the thermally stable aluminium hydroxide.

The laminates may be based on epoxy resin which allows a batch process to be used. The laminates may also be produced by continuous process using unsaturated polyester or vinyl ester, i. e., resins which polymerize via a free radical mechanism. The nature of the invention however does not limit the manufacturing technique for the laminate.

When the production of the laminate is based on epoxy resin, as a rule two layers of woven glass preimpregnated with the epoxy resin are combined with three layers of non-woven glass preimpregnated with epoxy resin containing thermally stable aluminium hydroxide. These five layers are usually then combined with one or two layers of copper foil on the outside and the assembly subjected to heat and pressure to polymerize the resin and consolidate the laminate.

Most epoxy resins used for electrical and electronic applications are derived from bisphenol A or cycloaliphatic species The most common curing agent is dicyandiamide.

According to the method of the present invention, the intermediate layer(s) comprising curable resin impregnated non-woven glass contain(s) 200 % by weight to 275 % by weight, preferably 225 % by weight to 250 % by weight, of the non hygroscopic thermally stable aluminium hydroxide according to claims 1 to 5.

The incorporation of the non hygroscopic thermally stable aluminium hydroxide into the curable resin can be accomplished by methods known to those skilled in the art, i. e., usually by introducing the filler - either after its silane treatment according to claims 6 to 9, in the form of a dispersion in the respective solvent or recovered from the silane treatment and dried, in solid form - into the predissolved mixture of resin and curing agent using suitable equipment such as shearing head mixer. If needed, other inorganic thermally stable fillers may be added to the formulation such as fine silica, clay or talc, although none of these would significantly enhance fire properties.

Further processing of the resin / filler mix to the 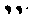 prepreg" stage and then to the cured laminate is common state of the art and described in the literature, an example of which is 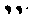 Handbook of Epoxide Resins", published by the McGraw-Hill Book Company.

The cured laminate according to the present invention shows further enhanced thermal stability when compared to laminates prepared according to GB patent application 9700708.2; when immersed in molten solder at 260 °C, it shows no signs of blistering or bubbling for a period of over 90 seconds. The laminate also has excellent fire retardancy characteristics and meets the requirements of UL 94 V-0.

### Examples:

### 1. Production of a thermally stable aluminum hydroxide.

Fine crystals of aluminium hydroxide (average size 1 - 2 µm) are agglomerated to ca. 60 µm average size by using a seed charge of 50 kg/dm³ sodium aluminate solution of following concentration: Na₂O - 140 kg/dm³, Al₂O₃ - 150 kg/dm³, total Na₂O - 150 kg/dm³. The working capacity of the crystallizer was 1 m³. Crystallization temperature was 75 °C with a retention time of 24 h.
Alumina liquor productivity was Ca. 40 kg/dm³. The product of crystallization was washed with deionized water and dried at 105 °C for 4 h.

Size reduction of the aluminium hydroxide particles was effected by means of a vibration mill (type Palla 200 of the KHD company). The milling conditions were as follows:
motor - 1000 rpm; loading of cylpebs - ca. 65 % by volume; Cylpebs dimensions - 12 mm x 12 mm aluminium oxide; mill throughput ca. 50 kg/h. Under these conditions, the feed aluminium hydroxide was reduced in size to the dimensions given in Table 1.

The final step of thermal stabilization was achieved by lowering the water loss on ignition from the 34.5 wt.% of the size reduced material to ca. 31 wt.% by heating in an electric oven operating at a temperature of 220 °C for a time of ca. 2 h. The properties of the thermally stable material are also given in Table 1.

**Table 1**

| **Physical Parameter** | |
|---|---|
| | |
| **Al**_{**2**}**O**_{**3**}**.nH**_{**2**}**O** 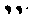 **n"** | 2.7 |
| **Particle size D10% (µm)** | 1.0 |
| **Particle size D50% (µm)** | 7.5 |
| **Particle size D90% (µm)** | 28.0 |
| **Specific Surface Area m**^{**2**}**/g)** | 6.0 |
| | |
| **Oil Absorption (ml/100 g)** | 28.0 |

### 2. Silane Treatment of the thermally stable aluminum hydroxide of ex. 1

100 g of thermally stable aluminum hydroxide as of example 1 are dispersed in 500 ml acetone. The mixture is dispersed under a shearing head mixer for 20 minutes. After this time 0,75 g of an aminoalkylsilane (A1100 of Witco) were added. After further stirring for 5 minutes, the solvent is evaporated and the non hygroscopic thermally stable aluminum hydroxide is collected having the following characteristics:

| **Physical Parameter** | |
|---|---|
| | |
| **Al**_{**2**}**O**_{**3**}**.nH**_{**2**}**O** 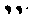 **n"** | 2.7 |
| **Particle size D10% (µm)** | 1.0 |
| **Particle size D50% (µm)** | 7.5 |
| **Particle size D90% (µm)** | 28.0 |
| **Specific Surface Area m**^{**2**}**/g)** | 5.5 |
| **Oil Absorption (ml/100 g)** | 20.0 |
| **Silane content (wt.%)** | 0.4 |

### 3. Preparation of the laminate (Batch Process)

100 parts of an epoxy resin with epoxy equivalent of 400 - 500 (DOW DER 652) dissolved in 30 parts of acetone is mixed with 4 parts of dicyandiamide predissolved in 36 parts of 2-methoxy ethanol. To this mix is added 0.1 parts of 2-methyl imidazole to accelerate the resin cure (Mix A).

Woven glass fabric (style 7628 manufactured by Interglass) is impregnated with the Mix A to a resin content of 42 %, and the resin B-staged for 2 min. at 160 °C to produce a dry prepreg.
250 phr of thermally stable aluminum hydroxide as of example 1 are dispersed in one third of its weight of a cetone . The mixture is dispersed under a shearing head mixer for 20 minutes. After this time 0,75 wt.% relative to the amount of thermally stable aluminium hydroxide of an aminoalkylsilane (A1100 of Witco) were added. (Mix B).

Separately, to Mix A were added 250 phr (i. e., parts per hundred resin) of a) the thermally stable aluminum hydroxide and b) the non hygroscopic thermally stable aluminium hydroxide according to the invention in the form of Mix B. Both mixes are impregnated into non-woven glass (type E 105 manufactured by Owens Corning) to give weight corresponding to 90 % of the total. The thermally stable aluminum hydroxide was predispersed in an amount of acetone commensurate with achieving the final mix viscosity. The resin system is then B-staged for 3 mm. at 160 °C to produce a dry, manageable prepreg.

Three of the non-woven glass prepreg layers are sandwiched between two woven glass prepreg layers. This assembly has copper foil placed on both sides and the pack laminated at 180 °C at a pressure of 50 bar for 90 mm. to produce a copper clad laminate 1.6 mm thick.

### Test Results

Comparison is made between a) the thermally stable aluminium hydroxide according to GB 9700708.2 and b) the non hygroscopic thermally stable aluminium hydroxide of the invention.

Solder resistance is measured by frilly immersing the laminate in molten solder at 260 °C. When the aluminium hydroxide starts to decompose it is possible to hear the laminate blistering and the escaping water causes "waves" at the solder surface. The time is measured until the blistering / waves are detected.

The flammability is defined by the American Underwriters Laboratory UL 94 standard which categorizes performance on combustion as V-0 (the best), V-1 and HB (the worst). For pcb applications laminates have to meet the V-0 category.

**Table 2**

| **Solder Resistance and Flammability Test Results** | | | | |
|---|---|---|---|---|
| **Test** | **Laminate with thermally stable aluminum hydroxides (ts-ATH) (GB 9700708.2)** | | | **Laminate with non hygroscopic thermally stable aluminium hydroxide (invention)** |
| **amount (phr)** | 250 | 250 | 250 | 250 |
| **time after production of ts- ATH (month)** | I | 2 | 6 | 6 |
| **Solder Resistance (s)** | >90 s | 40 s | <20 s | >90 s |
| **Flammable UL 94** | V0 | - | - | V0 |

## Claims

1. Non hygroscopic thermally stable aluminium hydroxide, comprising a thermally stable aluminium hydroxide of he molecular formula Al₂O₃.nH₂O wherein n has a value of >2.6 to <2.9 which is surface treated with a silane.

2. Non hygroscopic thermally stable aluminium hydroxide according to claim 1, the thermally stable aluminium hydroxide having a particle size in the D50% range of 5 to 10 µm.

3. Non hygroscopic thermally stable aluminium hydroxide according to claim 1 or 2, the thermally stable aluminium hydroxide having a particle size in the D10% range of 0.5 to 1.5 µm and in the D90% range of 20 to 35 µm.

4. Non hygroscopic thermally stable aluminium hydroxide according to any one of claims 1 to 3 wherein the silane is chosen from an aminoalkylsilane, an epoxyalkylsilane or a vinylsilane.

5. Non hygroscopic thermally stable aluminium hydroxide according to any one of claims 1 to 4 wherein the silane content on the thermally stable aluminium hydroxide is between 0.1 wt.% and 2.0 wt.%, relating to the thermally stable aluminium hydroxide.

6. Process for preparing a non hygroscopic thermally stable aluminium hydroxide according to claim 1 comprising treating a thermally stable aluminium hydroxide of the molecular formula Al₂O₃.nH₂O wherein n has a value of >2.6 to <2.9, preferebly having a particle size in the D50% range of 5 to 10 µm, in the D10% range of 0.5 to 1.5 µm and in the D90% range of 20 to 35 µm, with a silane in the presence of a ketone as solvent.

7. Process according to claim 6 characterized in that as a suitable silane an aminoalkylsilane, an epoxyalkylsilane or a vinylsilane is used.

8. Process according to claim 6 or 7, characterized in that the silane is added in an amount of 0.1 wt.% to 2.0 wt.% relating to the thermally stable aluminium hydroxide.

9. Process according to any one of claims 6 to 8 characterized in that acetone is used as solvent.

10. Laminate for printed circuit boards having surface layers comprising resin impregnated woven glass fabric and one or more intermediate layer(s) comprising curable resin impregnated non-woven glass, characterized in that the intermediate layer(s) contain(s) 200 % by weight to 275 % by weight based on the resin in the intermediate layer(s) of a non hygroscopic thermally stable aluminium hydroxide according to any one of claims 1 to 5.

11. Laminate according to claim 10, wherein as a curable resin an unsaturated polyester resin, an epoxy resin or a vinyl ester resin is applied.

12. Method for the preparation of a laminate for printed circuit boards by composing together surface layers comprising curable resin impregnated woven glass fabric and one or more intermediate layer(s) comprising curable resin-impregnated non-woven glass, characterized in that the curable resin-impregnated non-woven glass contains 200 % by weight to 275 % by weight based on the resin in the intermediate layer(s) of a non hygroscopic thermally stable aluminium hydroxide according to any one of claims 1 to 5.

13. Method according to claim 12 wherein as a curable resin an unsaturated polyester resin, an epoxy resin or a vinyl ester resin is applied.

14. Method according to claim 12 or 13 characterized in that the non hygroscopic thermally stable aluminium hydroxide according to claims 1 to 5 is either added in the form of a dispersion in a ketone to the curable resin-impregnated non woven glass just after its production according to claims 6 to 9 or dried in solid form

15. Printed circuit board comprising a laminate according to any one of claims 10 to 11 or obtainable by a method according to any one of claims 12 to 14.
